# EUROPEAN PATENT APPLICATION

(11) **EP 4 301 108 A1**
(43) Date of publication of application: **03.01.2024**
(21) Application number: 23166859.1
(22) Date of filing: 05.04.2023
(51) Int. Cl.: H10B 43/27, H10B 41/27

(54) **SEMICONDUCTOR DEVICES AND DATA STORAGE SYSTEMS INCLUDING THE SAME**

(30) Priority: 01.07.2022 KR 20220081103
(71) Applicant: Samsung Electronics Co., Ltd., Suwon-si, Gyeonggi-do 16677 (KR)
(72) Inventor: KIM, Jiwon, 16677 Suwon-si (KR); KIM, Dohyung, 16677 Suwon-si (KR); KIM, Jiyoung, 16677 Suwon-si (KR); SUNG, Sukkang, 16677 Suwon-si (KR)
(74) Representative: Marks & Clerk LLP

(57) **Abstract**

An integrated circuit device includes a semiconductor substrate, and a common source structure on the substrate. A vertical stack of memory cell gate electrodes is provided, which extends between the common source structure and the substrate. The vertical stack of memory cell gate electrodes includes a first erase control gate electrode, and a plurality of word lines extending between the first erase control gate electrode and the substrate. At least one channel structure is provided, which vertically penetrates through the vertical stack of memory cell gate electrodes. A source protrusion pattern is provided, which is electrically connected to the common source structure. The source protrusion pattern extends sufficiently through the vertical stack of memory cell gate electrodes that a portion of the source protrusion pattern extends opposite a sidewall of the first erase control gate electrode.

## Description

### BACKGROUND

Example embodiments of the present disclosure relate to integrated circuit devices, and data storage systems including the same.

An integrated circuit device capable of storing high-capacity data in a data storage system is needed. Methods for increasing data storage capacities of semiconductor devices have been researched. For example, one method for increasing data storage capacity of an integrated circuit device includes using semiconductor devices having memory cells that are fabricated three-dimensionally, instead of memory cells that are fabricated two-dimensionally.

### SUMMARY

An example embodiment of the present disclosure is to provide an integrated circuit device having improved electrical properties.

An example embodiment of the present disclosure is to provide a data storage system including an integrated circuit device having improved electrical properties.

According to an example embodiment of the present disclosure, an integrated circuit device includes a first structure including a substrate, circuit devices on the substrate, a lower wiring structure electrically connected to the circuit devices, and a lower bonding structure on the lower wiring structure. A second structure is also provided, which includes a source structure on the first structure, gate electrodes between the first structure and the source structure, channel structures penetrating through the gate electrodes, an upper wiring structure below the gate electrodes and the channel structures, and an upper bonding structure below the upper wiring structure. This upper bonding structure is bonded to the lower bonding structure. In some embodiments, the gate electrodes include a first erase control gate electrode, a second erase control gate electrode below the first erase control gate electrode, and word lines between the first erase control gate electrode and the second erase control gate electrode. The channel structures also include a core insulating layer, a channel layer surrounding a side surface of the core insulating layer, a gate dielectric layer between the channel layer and the gate electrodes, and a pad pattern in contact with a lower region of an internal side surface of the channel layer. In addition, the source structure includes a first pattern in contact with an upper region of a side surface of the gate dielectric layer and a second pattern on the first pattern. A first groove is provided, which is recessed into an upper portion of the core insulating layer to a level lower than a level of a lower surface of the first erase control gate electrode is disposed in the channel structures. The second pattern includes a source protrusion pattern extending into the first groove, in contact with an upper region of an internal side surface of the channel layer and overlapping the first erase control gate electrode in a horizontal direction.

According to another embodiment, an integrated circuit device is provided includes a first structure including a substrate, circuit devices on the substrate, a lower wiring structure electrically connected to the circuit devices, and a lower bonding structure on the lower wiring structure. A second structure is also provided, which includes a source structure on the first structure, gate electrodes between the first structure and the source structure, channel structures disposed in channel holes and penetrating through the gate electrodes, an upper wiring structure below the gate electrodes, and an upper bonding structure below the upper wiring structure and bonded to the lower bonding structure. The gate electrodes may include a first erase control gate electrode, a second erase control gate electrode below the first erase control gate electrode, and word lines between the first erase control gate electrode and the second erase control gate electrode. Each of the channel structures may include a core insulating layer, a channel layer surrounding a side surface of the core insulating layer, a gate dielectric layer between the channel layer and the gate electrodes, and a pad pattern overlapping a lower region of the channel layer and the second erase control gate electrode in a horizontal direction. In some embodiments, the source structure may include source extension portions extending into the channel holes, respectively. In addition, each of the source extension portions may overlap an upper region of the channel layer and the first erase control gate electrode in the horizontal direction.

According to another example embodiment of the present disclosure, a data storage system includes a semiconductor storage device including a first structure including a substrate, circuit devices on the substrate, and a lower bonding structure on the circuit devices. A second structure is also provided, which includes a source structure, gate electrodes below the source structure, channel structures disposed in channel holes and penetrating through the gate electrodes, and an upper bonding structure below the gate electrodes and the channel structures and bonded to the lower bonding structure, and an input/output pad electrically connected to the circuit devices, and a controller electrically connected to the semiconductor storage device through the input/output pad and configured to control the semiconductor storage device. The gate electrodes may also include a first erase control gate electrode, a second erase control gate electrode below the first erase control gate electrode, and word lines between the first erase control gate electrode and the second erase control gate electrode. Each of the channel structures may include a core insulating layer, a channel layer surrounding a side surface of the core insulating layer, a gate dielectric layer between the channel layer and the gate electrodes, and a pad pattern below the core insulating layer. A first groove may be provided, which is recessed into an upper portion of the core insulating layer to a level lower than a level of a lower surface of the first erase control gate electrode. A second groove may be provided, which is recessed into a lower portion of the core insulating layer to a level higher than a level of an upper surface of the second erase control gate electrode in each of the channel structures. The source structure may include a source protrusion pattern extending into the first groove, and the pad pattern may be disposed in the second groove.

According to another embodiment of the present disclosure, a method of manufacturing an integrated circuit device includes forming a peripheral circuit region including a substrate, circuit devices on the substrate, and a lower wiring structure and a lower bonding structure on the circuit devices. In addition, a memory cell region is formed. This memory cell region includes a rear structure, a stack structure including interlayer insulating layers and gate electrodes alternately stacked on the rear structure, vertical structures penetrating through the stack structure, and an upper wiring structure and an upper bonding structure on the stack structure. The peripheral circuit region is bonded to the memory cell region such that the lower bonding structure and the upper bonding structure are bonded to each other. The backside structure includes a backside substrate, an etch-stop layer on the backside substrate, and a first pattern on the etch-stop layer. The vertical structures penetrate through the first pattern and are in contact with the etch-stop layer. The gate electrodes include a first erase control gate electrode, the second erase control gate electrode, and word lines between the first erase control gate electrode and the second erase control gate electrode. The method may further include removing the backside substrate and the etch-stop layer after the bonding the peripheral circuit region to the memory cell region. The channel layer and the core insulating layer of the vertical structures are exposed by etching the gate dielectric layer of the vertical structures. A first groove is also formed, which is recessed into an upper portion of the core insulating layer to a level lower than a level of a lower surface of a first erase gate electrode among the gate electrodes. A second pattern is formed in the first groove and on the first pattern.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is an exploded perspective diagram illustrating an integrated circuit device according to an example embodiment of the present disclosure;
FIG. 2 is a cross-sectional diagram illustrating an integrated circuit device according to an example embodiment of the present disclosure;
FIGS. 3A and 3B are enlarged cross-sectional diagrams illustrating a portion of an integrated circuit device according to an example embodiment of the present disclosure;
FIGS. 4A, 4B, 4C, 4D, 4E, 4F, and 4G are enlarged cross-sectional diagrams illustrating a portion of an integrated circuit device according to an example embodiment of the present disclosure;
FIGS. 5A, 5B, 5C, and 5D are enlarged cross-sectional diagrams illustrating a portion of an integrated circuit device according to an example embodiment of the present disclosure;
FIGS. 6A and 6B are enlarged cross-sectional diagrams illustrating a portion of an integrated circuit device according to an example embodiment of the present disclosure;
FIG. 7 is an enlarged cross-sectional diagram illustrating a portion of an integrated circuit device according to an example embodiment of the present disclosure;
FIGS. 8, 9A, 9B, 9C, 9D, 9E, and 9F are cross-sectional diagrams illustrating a method of manufacturing an integrated circuit device according to an example embodiment of the present disclosure;
FIG. 10 is a diagram illustrating a data storage system including an integrated circuit device according to an example embodiment of the present disclosure;
FIG. 11 is a perspective diagram illustrating a data storage system including an integrated circuit device according to an example embodiment of the present disclosure; and
FIG. 12 is a cross-sectional diagram illustrating a semiconductor package according to an example embodiment of the present disclosure.

### DETAILED DESCRIPTION

Hereinafter, embodiments of the present disclosure will be described as follows with reference to the accompanying drawings.

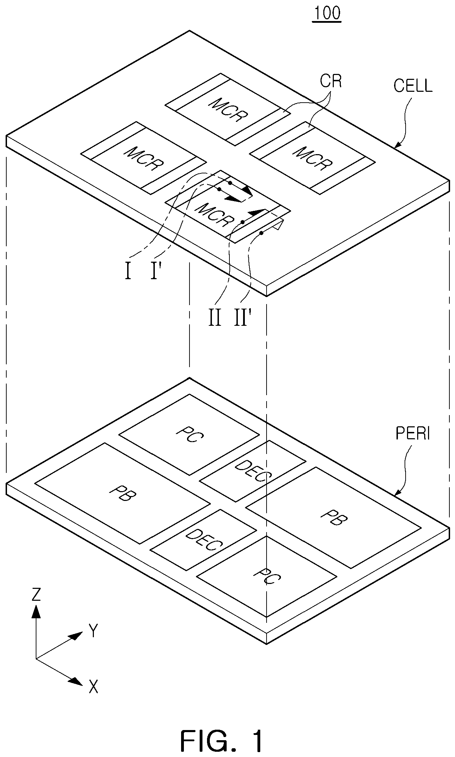

FIG. 1 is an exploded perspective diagram illustrating an integrated circuit device according to an example embodiment. Referring to FIG. 1, an integrated circuit device 100 according to example embodiments may include a peripheral circuit region PERI and a memory cell region CELL stacked in the vertical direction Z. The peripheral circuit region PERI and the memory cell region CELL may be bonded to each other. The memory cell region CELL may include a memory cell array region MCR and a connection region CR. In contrast, the peripheral circuit region PERI may include a row decoder DEC, a page buffer PB, and other peripheral circuits PC. In the peripheral circuit region PERI, the row decoder DEC may decode an input address and may generate and transmit driving signals of a word line. The page buffer PB may be connected to the memory cell array region MCR through bit lines and may read information stored in the memory cells. The other peripheral circuits PC may be a region including a control logic and a voltage generator, and may include, for example, a latch circuit, a cache circuit, and/or a sense amplifier. The peripheral circuit region PERI may further include a pad region, and in this case, the pad region may include an electrostatic discharge (ESD) device or a data input/output circuit. The various circuit regions DEC, PB, and PC in the peripheral circuit region PERI may be disposed in various shapes.

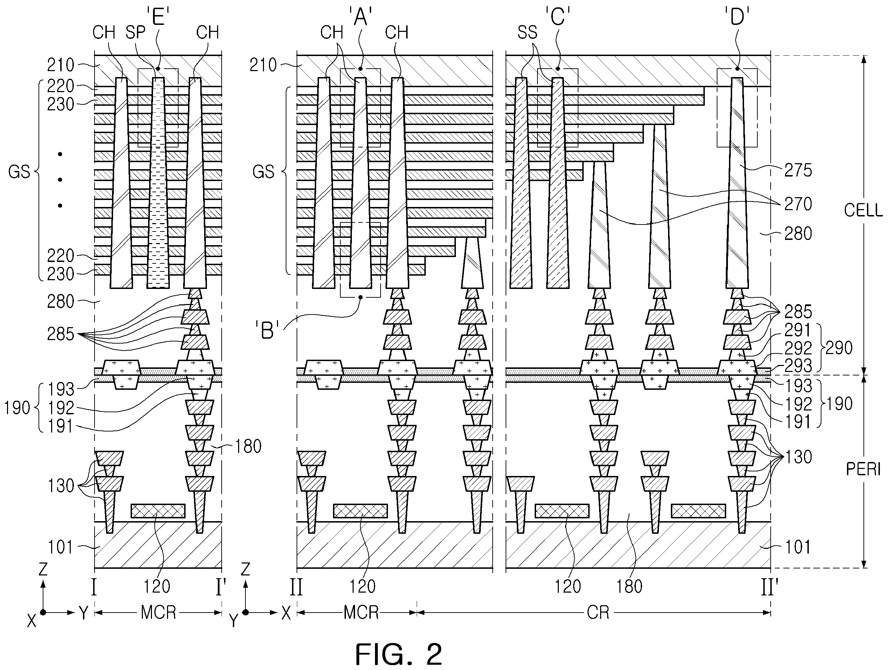

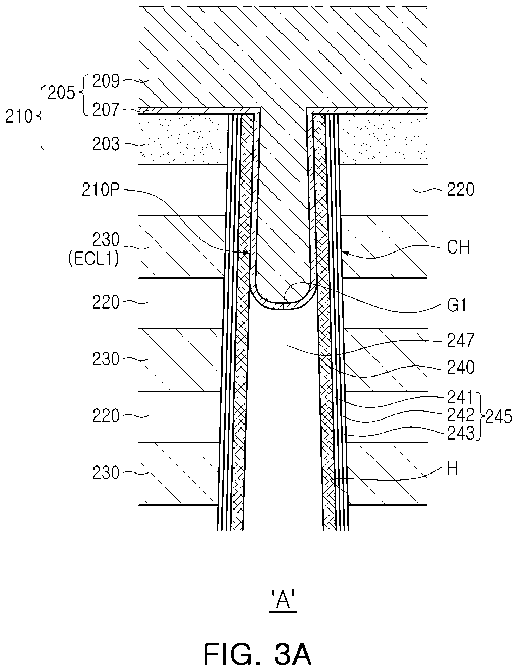

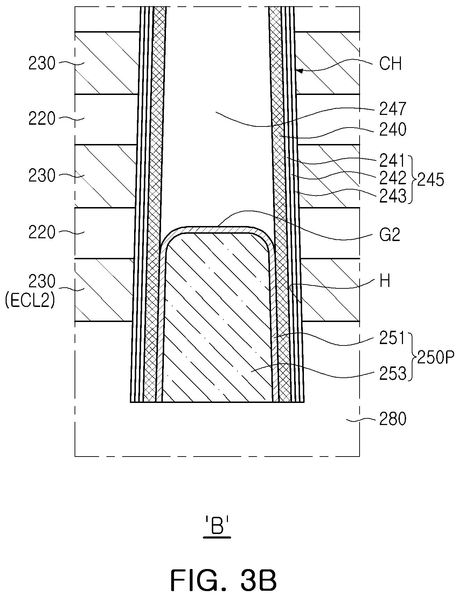

FIG. 2 is a cross-sectional diagram illustrating an integrated circuit device according to an example embodiment, taken along lines I-I' and II-II' in FIG. 1. FIGS. 3A and 3B are enlarged cross-sectional diagrams illustrating a portion of an integrated circuit device according to an example embodiment. In particular, FIG. 3A is a cross-sectional diagram illustrating region "A" in FIG. 2, and FIG. 3B is a cross-sectional diagram illustrating region "B" in FIG. 2.

Referring to FIGS. 2 to 3B, the integrated circuit device 100 may include a peripheral circuit region PERI and a memory cell region CELL. The memory cell region CELL may be disposed on the peripheral circuit region PERI. The peripheral circuit region PERI and the memory cell region CELL may be bonded to each other using bonding structures 190 and 290. In example embodiments, the peripheral circuit region PERI may be referred to as a "first structure," and the memory cell region CELL may be referred to as a "second structure."

The peripheral circuit region PERI may include a substrate 101, circuit devices 120 disposed on the substrate 101, a lower wiring structure 130, a lower insulating structure 180, and a lower bonding structure 190. As will be understood by those skilled in the art, the substrate 101 may include a semiconductor material, such as, for example, a group IV semiconductor, a group III-V compound semiconductor, or a group II-VI compound semiconductor. In some embodiments, the substrate 101 may be provided as a bulk wafer or as an epitaxial layer. An active region may be defined in the substrate 101 by device isolation layers. Source/drain regions including impurities may be disposed in a portion of the active region.

The circuit devices 120 may include a transistor. Each of the circuit devices 120 may include a circuit gate electrode, a circuit gate dielectric layer disposed between the circuit gate electrode and the substrate 101, and a source/drain disposed in an active region of the substrate 101 on both sides of the circuit gate electrode. The lower wiring structure 130 may be electrically connected to the circuit devices 120. The lower wiring structure 130 may include lower contact plugs and lower wirings (e.g., patterned metal traces). The lower wirings may be electrically connected to each other through the lower contact plugs. The lower wiring structure 130 may include a conductive material, such as, for example, tungsten (W), copper (Cu), aluminum (Al), and the like, and each of the components may further include a diffusion barrier including at least one of titanium (Ti), titanium nitride (TiN), tantalum (Ta), tantalum nitride (TaN), and tungsten nitride (WN). In example embodiments, the number of layers and arrangement of the lower contact plugs and the lower wirings included in the lower wiring structure 130 may be varied.

The lower insulating structure 180 may be disposed on the substrate 101 and may cover the circuit devices 120 and the lower wiring structure 130. The lower insulating structure 180 may include a plurality of insulating layers. The lower insulating structure 180 may include an insulating material, such as, for example, at least one of silicon oxide, silicon nitride, silicon oxynitride, and silicon oxycarbide.

The lower bonding structure 190 may be disposed on the lower wiring structure 130. The lower bonding structure 190 may be electrically connected to the lower wiring structure 130. The lower bonding structure 190 may include a lower bonding via 191, a lower bonding pad 192, and a lower bonding insulating layer 193. The lower bonding via 191 may be connected to the lower wiring structure 130. The lower bonding pad 192 may be connected to the lower bonding via 191. The lower bonding via 191 and the lower bonding pad 192 may include a conductive material, such as, for example, tungsten (W), copper (Cu), and aluminum (Al), and each of the components may further include a diffusion barrier. The lower bonding insulating layer 193 may also function as a diffusion barrier layer of the lower bonding pad 192, and may include at least one of SiCN, SiO, SiN, SiOC, SiON, and SiOCN. The lower bonding insulating layer 193 may have a thickness smaller than that of the lower bonding pad 192, but an example embodiment thereof is not limited thereto.

The lower bonding structure 190 may be bonded or connected to the upper bonding structure 290 by being in direct contact with the upper bonding structure 290 by hybrid bonding. For example, the lower bonding pad 192 may be in contact with and bonded to the upper bonding pad 292 by copper (Cu)-to-copper (i.e., metal-to-metal) bonding, and the lower bonding insulating layer 193 may be in contact with, and bonded to, the upper bonding insulating layer 293 by dielectric-to-dielectric bonding. The lower bonding structure 190 may provide an electrical connection path between the peripheral circuit region PERI and the memory cell region CELL together with the upper bonding structure 290.

The memory cell region CELL may include a source structure 210 including a memory cell array region MCR and a connection region CR, a stack structure GS including interlayer insulating layers 220 and gate electrodes 230 disposed below the source structure 210, channel structures CH penetrating through the stack structure GS in the memory cell array region MCR, an isolation pattern SP penetrating through the stack structure GS and extending in the X direction, support structures SS penetrating through the stack structure in the connection region CR, gate contact plugs 270 connected to the gate electrodes 230, source contact plugs 275 connected to the source structure 210, an upper insulating structure 280, an upper wiring structure 285 disposed in the upper insulating structure 280, and an upper bonding structure 290 disposed below the upper wiring structure 285.

The source structure 210 may include a semiconductor material, such as, for example, a group IV semiconductor, a group III-V compound semiconductor, or a group II-VI compound semiconductor. For example, the group IV semiconductor may include silicon (Si), germanium (Ge), or silicon-germanium (SiGe). The source structure 210 may include a conductive material, and may include impurities or doped regions including impurities. For example, the source structure 210 may be formed of polysilicon having N-type conductivity. The source structure 210 may be in contact with the channel structures CH and may provide a common source region. A separate insulating layer for protecting the source structure 210 may be further disposed on the source structure 210. In another example, the source structure 210 may include at least one of a metal material such as tungsten (W), titanium (Ti), tantalum (Ta), copper (Cu), aluminum (Al), molybdenum (Mo), and ruthenium (Ru), and a metal-semiconductor compound such as tungsten silicide (WSi) and titanium silicide (TiSi).

As illustrated by FIG. 3A, the source structure 210 may include a first pattern 203 and a second pattern 205 disposed on the first pattern 203. The first pattern 203 may be in contact with an upper region of a side surface of the gate dielectric layer 245 and may extend horizontally. The first pattern 203 may include a semiconductor material such as polysilicon. For example, the first pattern 203 may include polysilicon including N-type impurities. The first pattern 203 may be penetrated by the gate dielectric layer 245 and the channel layer 240.

The second pattern 205 may include a source protrusion pattern 210P partially extending into the channel hole H. The source protrusion pattern 210P may be disposed in a first groove G1 recessed into an upper portion of the core insulating layer 247 to a level lower than a level of a lower surface of the first erase gate electrode ECL1 in the channel structure CH. The source protrusion pattern 210P may be in contact with an upper region of an internal side surface of the channel layer 240, and may overlap an upper region of the channel layer 240 and the first erase gate electrode ECL1 in a horizontal direction. The source protrusion pattern 210P may have a width decreasing upwardly. The source protrusion pattern 210P may be referred to as a "source extension portion."

The second pattern 205 may include a first layer 207 including undoped (not intentionally doped) polysilicon and a second layer 209 including polysilicon including N-type impurities. The first layer 207 may have a "U" shape or a shape similar thereto in the first groove G1. The first layer 207 may be in contact with the upper region of the internal side surface of the channel layer 240 in the first groove G1. The first layer 207 may extend horizontally to an upper surface of the gate dielectric layer 245 and an upper surface of the first pattern 203. The second layer 209 may fill at least a portion of an internal space of the first portion 207 in the first groove G1. An interfacial surface between the first layer 207 and the second layer 209 may be distinct or indistinct. However, even when the interfacial surface between the first layer 207 and the second layer 209 is not distinct, the interfacial surface may be distinct by a difference in concentrations of impurities between the first layer 207 and the second layer 209. The type of impurities and distribution of concentration (or profile) of impurities may be identified by energy dispersive x-ray spectroscopy (EDX), X-ray fluorescence spectrometry (XRF), X-ray photoelectron spectrometry (XPS), atomic probe tomography (APT) or secondary ion mass spectrometry (SIMS).

The first layer 207 and the second layer 209 may be distinct from each other in the drawings for ease of description, but when it is difficult to identify the interfacial surface, the first layer 207 may be referred to as a "first portion 207" having a relatively low impurities concentration, and the second layer 209 may be referred to as a "second portion 209" having a relatively high impurities concentration. For example, the first portion 207 may include N-type impurities diffused from the second portion 209 in a first concentration, the second portion 209 may include N-type impurities in a second concentration, and the first concentration may be less than the second concentration.

The first layer 207 may work as a diffusion buffer layer between the channel layer 240 and the second layer 209. For example, to form a depletion region, the first layer 207 may diffuse impurities from the second layer 209 and may form a concentration gradient of the impurities, thereby buffering the diffusion of impurities. A depletion region may be formed in one region of the first layer 207 overlapping the first erase control gate electrode ECL1 in a horizontal direction. During an erase operation of the integrated circuit device 100, electron-hole pairs may be formed in the depletion region such that a gate induced drain leakage (GIDL) current may be induced.

In the absence of the source protrusion pattern 210P or the first layer 207 extending into the first groove G1, a GIDL current in which the longitudinal Band-To-Band-Tunneling (BTBT) in the vertical direction prevails may be generated in the channel layer 240 during the erase operation of the integrated circuit device. In this case, since the GIDL generation area corresponds to the region in which the upper end of the channel layer 240 is in contact with the common source region, the area in which the depletion region is formed may be relatively small, such that the GIDL generation efficiency may not be high. In an example embodiment, by allowing the source protrusion pattern 210P to overlap the first erase control gate electrode ECL1 in the horizontal direction, the area in which the GIDL current is generated during the erase operation of the integrated circuit device may be increased. Since the first layer 207, which is a diffusion buffer layer, horizontally overlaps the first erase control gate electrode ECL1, a GIDL current in which a transverse BTBT in the horizontal direction prevails may be generated between the channel layer 240 and the first layer 207, such that the area in which the GIDL current is generated may increase by the overlapping area. By increasing the GIDL current generating region, the efficiency of generating the GIDL current may improve during the erase operation of the integrated circuit device.

The gate electrodes 230 may be vertically stacked and spaced apart from each other below the source structure 210 and may form a portion of the stack structure GS. The gate electrodes 230 may be disposed between the source structure 210 and the upper wiring structure 285. The gate electrodes 230 may be stacked and spaced apart from each other in the vertical direction Z below the memory cell array region MCR, and may extend in the X direction and may form a stepped structure in the form of a staircase below the connection region CR. Due to the stepped structure, the gate electrodes 230 may form a staircase shape in which the upper gate electrode 230 extends longer than the lower gate electrode 230, and may provide ends exposed toward the substrate 101 from the interlayer insulating layers 220. In example embodiments, the gate electrodes 230 may have an increased thickness on the ends.

Each of the gate electrodes 230 may include a first layer and a second layer. The first layer may cover upper and lower surfaces of the second layer and may extend to a region between the channel structures CH and the second layer. The first layer may include a high-κ material such as aluminum (AIO), and the second layer may include at least one of titanium (Ti), titanium nitride (TiN), tantalum (Ta), tantalum nitride (TaN), tungsten (W), and tungsten nitride (WN). In example embodiments, the gate electrodes 230 may include polysilicon or a metal-semiconductor compound.

The gate electrodes 230 may include erase control gate electrodes ECL1 and ECL2 forming gates of erase transistors used in an erase operation using a gate induced drain leakage (GIDL) current phenomenon. The erase gate electrodes ECL1 and ECL2 may include a first erase gate electrode ECL1 and a second erase gate electrode ECL2 disposed below the first erase control gate electrode ECL1. The gate electrodes 230 may include ground select lines forming a ground select transistor between the first and second erase gate electrodes ECL1 and ECL2, word lines forming memory cells, and string select lines forming a string select transistor. Storage capacity of the integrated circuit device 100 may be determined according to the number of the gate electrodes 230 included in the memory cells.

The interlayer insulating layers 220 may be disposed between the gate electrodes 230. The interlayer insulating layers 220 may be spaced apart from each other and may extend in the X-direction on the lower surface of the source structure 210. The interlayer insulating layers 220 may include an insulating material such as silicon oxide or silicon nitride.

Each of the channel structures CH may form a memory cell string, and may be spaced apart from each other while forming rows and columns below the memory cell array region MCR. The channel structures CH may be disposed to form a grid pattern on the X-Y plane or may be disposed in a zigzag pattern in one direction. The channel structures CH may extend in the Z direction, may have a columnar shape, and may have an inclined side surface having a width decreasing toward the source structure 210 depending on an aspect ratio.

As illustrated in FIGS. 3A and 3B, each of the channel structures CH may include a channel layer 240, a gate dielectric layer 245, a core insulating layer 247, and a pad pattern 250P disposed in the channel hole H. The gate dielectric layer 245 may include a tunneling layer 241, a data storage layer 242, and a blocking layer 243 stacked in order from the channel layer 240.

The channel layer 240 may be formed in an annular shape surrounding the inner core insulating layer 247 in the channel structure CH, and may be disposed on the side surface of the core insulating layer 247. The channel layer 240 may cover the side surface of the core insulating layer 247, may extend upwardly longer than the upper surface of the core insulating layer 247, and may extend downwardly longer than the lower surface of the core insulating layer 247. An upper region and an upper end of the internal side surface of the channel layer 240 may be in contact with the source structure 210. The channel layer 240 may include a semiconductor material such as polysilicon. For example, the channel layer 240 may include undoped polysilicon, and may include P-type impurities or N-type impurities in example embodiments.

The gate dielectric layer 245 may be disposed between the gate electrodes 230 and the channel layer 240. The gate dielectric layer 245 may extend to the upper erase control gate electrode ECL1 and may extend to a region below the lower erase control gate electrode ECL2. The tunneling layer 241 may tunnel electric charges into the data storage layer 242. The tunneling layer 241 may include, for example, silicon oxide (SiO), silicon oxynitride (SiON), or a combination thereof. The data storage layer 242 may be a charge trap layer. The data storage layer 242 may include, for example, silicon nitride (SiN). The blocking layer 243 may include silicon oxide (SiO), silicon oxynitride (SiON), a high-κ dielectric material, or a combination thereof.

The core insulating layer 247 may have a cylindrical shape extending in the vertical direction Z. The core insulating layer 247 may include a first groove G1 formed by a recessed upper portion, and may include a second groove G2 formed by a recessed lower portion. The core insulating layer 247 may include silicon oxide or a lowk dielectric material. A width of the first groove G1 may be smaller than a width of the second groove G2.

The pad pattern 250P may be disposed in the second groove G2 recessed into the lower portion of the core insulating layer 247 to a level higher than a level of the upper surface of the second erase control gate electrode ECL2 in the channel structure CH. The pad pattern 250P may overlap the lower region of the channel layer 240 and the second erase control gate electrode ECL2 in the horizontal direction. The pad pattern 250P may have a width increasing downwardly. The lower end of the pad pattern 250P may be disposed on substantially the same level as a level of the lower end of the channel layer 240.

The pad pattern 250P may include a third layer 251 including undoped (not intentionally doped) polysilicon and a fourth layer 253 including polysilicon including N-type impurities. The third layer 251 may have a "U" shape or a shape similar thereto in the second groove G2. The third layer 251 may be in contact with the lower region of the internal side surface of the channel layer 240 in the second groove G2. The fourth layer 253 may fill at least a portion of an internal space of the third layer 251 in the second groove G2. The interfacial surface between the third layer 251 and the fourth layer 253 may be distinct or indistinct. However, even when the interfacial surface between the third layer 251 and the fourth layer 253 is not distinct, the third layer 251 and the fourth layer 253 may be distinct from each other by a difference in impurities concentration.

The third layer 251 and the fourth layer 253 may be distinct from each other in the drawings for ease of description, but when it is difficult to identify the interfacial surface, the third layer 251 may be referred to as a "third portion 251" in which concentration of impurities is relatively low, and the fourth layer 253 may be referred to as a "fourth portion 253" in which concentration of impurities is relatively high. For example, the third portion 251 may include N-type impurities diffused from the fourth portion 253 in a third concentration, the fourth portion 253 may include N-type impurities in a fourth concentration, and the third concentration may be less than the fourth concentration.

The pad pattern 250P also may include the third layer 251 and the fourth layer 253, and may overlap the second erase control gate electrode ECL2 in the horizontal direction, such that, as in the source protrusion pattern 210P, by increasing the GIDL generation area, the efficiency of generating GIDL current may improve during the erase operation of the integrated circuit device. In other words, during the erase operation of the integrated circuit device, the efficiency of generating GIDL current may improve through the source protrusion pattern 210P in an upper portion of the channel structure CH, and the efficiency of generating GIDL current may improve through the pad pattern 250P below the channel structure CH.

In another example, each of the channel structures CH may have a form in which a lower channel structure and an upper channel structure penetrating through the lower gate stacked group and the upper gate stacked group of the gate electrodes 230, respectively, may be connected to each other, and may have a bent portion by a difference or change in width in the connection region.

The isolation pattern SP may penetrate through the stack structure GS and may extend in the X direction. The isolation pattern SP may penetrate through the entirety of the gate electrodes 230 and may be in contact with the source structure 210. The isolation pattern SP may have a shape in which a width may decrease toward the source structure 210 due to a high aspect ratio. The isolation pattern SP may be formed of an insulating material such as silicon oxide or silicon nitride.

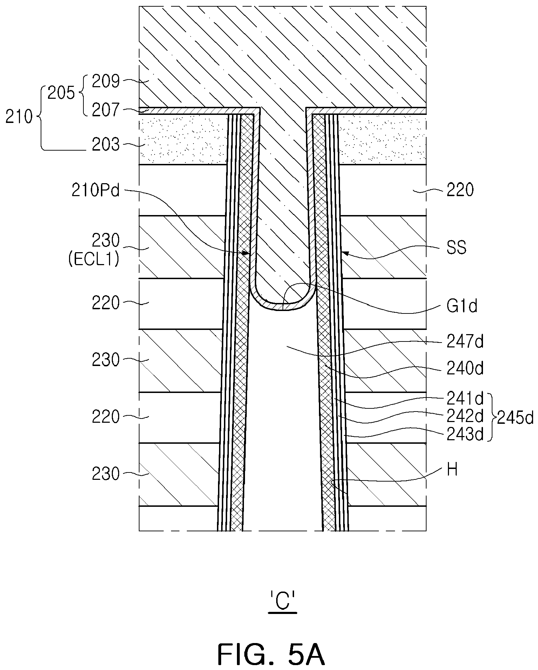

The support structures SS may penetrate through pad portions forming a staircase shape of the gate electrodes 230 below the connection region CR. The support structures SS may be formed in the same process of forming the channel structures CH and may have a structure the same as or similar to the channel structures CH. However, the support structures SS may not be electrically connected to the upper wiring structure 285, and may not perform a substantial function during operation of the integrated circuit device 100. The support structures SS may improve structural stability of the stack structure GS. The number of gate electrodes 230 penetrated by one of the support structures SS may be less than the number of gate electrodes 230 penetrated by one of the channel structures CH. Specific components included in the support structures SS will be described in greater detail with reference to FIGS. 5A to 5D.

The gate contact plugs 270 may penetrate through the upper insulating structure 280 and may be connected to the staircase-shaped pad portions of the gate electrodes 230. The gate contact plugs 270 may be connected to the upper wiring structure 285 in a lower portion. The gate contact plugs 270 may include a conductive layer and a barrier layer surrounding side surfaces and upper ends of the conductive layer. The conductive layer may include a conductive material, such as, for example, a metal material such as tungsten (W), copper (Cu), or aluminum (Al), and the barrier layer may include, for example, at least one of titanium (Ti), titanium nitride (TiN), tantalum (Ta), tantalum nitride (TaN), tungsten nitride (WN), and tungsten carbon nitride (WCN).

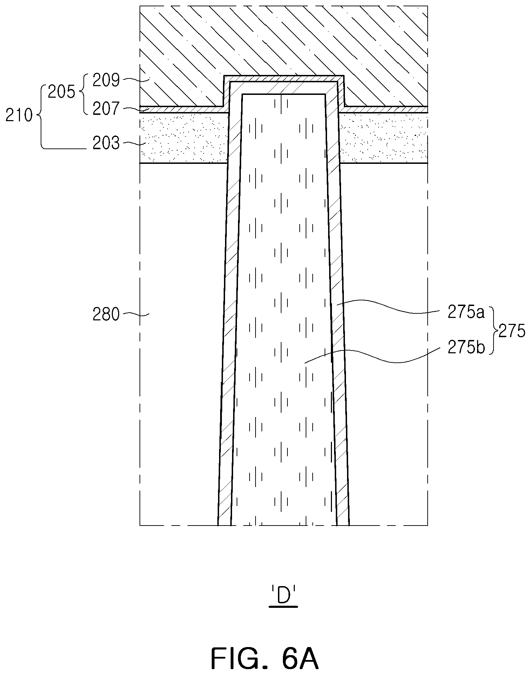

The source contact plug 275 may be spaced apart from the stack structure GS, and may have a shape having a width decreasing toward the source structure 210 due to an aspect ratio. For example, a width of an upper surface of the source contact plug 275 may be smaller than a width of a lower surface of the source contact plug 275. The source contact plug 275 may be disposed in the upper insulating structure 280 and may be connected to the source structure 210. Specific components included in the source contact plug 275 will be described in greater detail with reference to FIGS. 6A to 6B.

The upper insulating structure 280 may be disposed below the source structure 210 and may cover the source structure 210 and the stack structure GS. The upper insulating structure 280 may include a plurality of insulating layers. The upper insulating structure 280 may include an insulating material, such as, for example, at least one of silicon oxide, silicon nitride, silicon oxynitride, and silicon oxycarbide.

The upper wiring structure 285 may be electrically connected to the gate electrodes 230, the channel structures CH, the gate contact plugs 270, and the source contact plug 275. The upper wiring structure 285 may include upper contact plugs and upper wirings. The upper wirings may be electrically connected to each other through the upper contact plugs. The upper wiring structure 285 may include a conductive material, such as, for example, tungsten (W), copper (Cu), aluminum (Al), and the like, and each of the components may further include a diffusion barrier including at least one of titanium (Ti), titanium nitride (TiN), tantalum (Ta), tantalum nitride (TaN), and tungsten nitride (WN). In example embodiments, the number of layers and the arrangement of the lower contact plugs and the lower wirings included in the upper wiring structure 285 may be varied.

The upper bonding structure 290 may be disposed below the upper wiring structure 285. The upper bonding structure 290 may be electrically connected to the upper wiring structure 285. The upper bonding structure 290 may include an upper bonding via 291, an upper bonding pad 292, and an upper bonding insulating layer 293. The upper bonding pad 292 may be connected to the upper bonding via 291. The upper bonding via 291 and the upper bonding pad 292 may include a conductive material, such as, for example, tungsten (W), copper (Cu), and aluminum (Al), and each of the components may further include a diffusion barrier. The upper bonding insulating layer 293 may include at least one of SiCN, SiO, SiN, SiOC, SiON, and SiOCN.

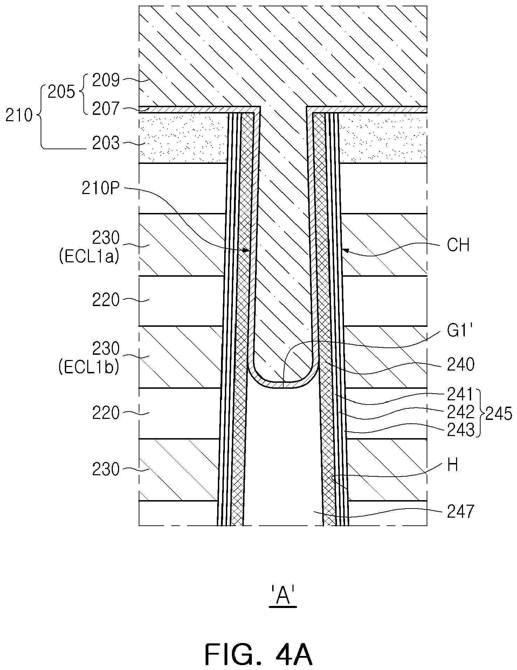

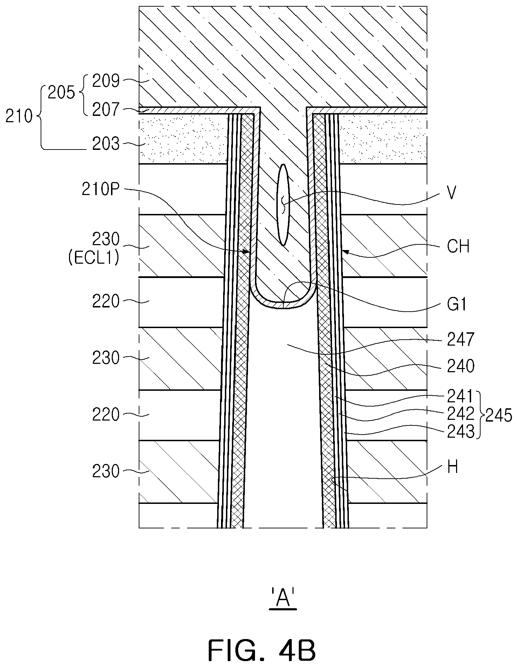

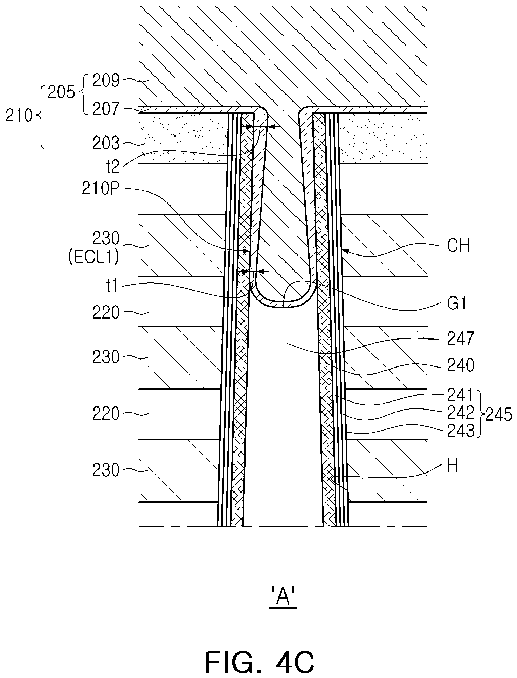

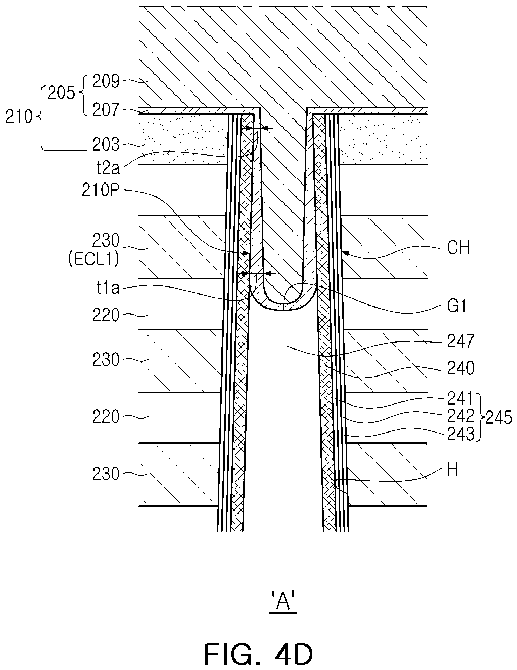

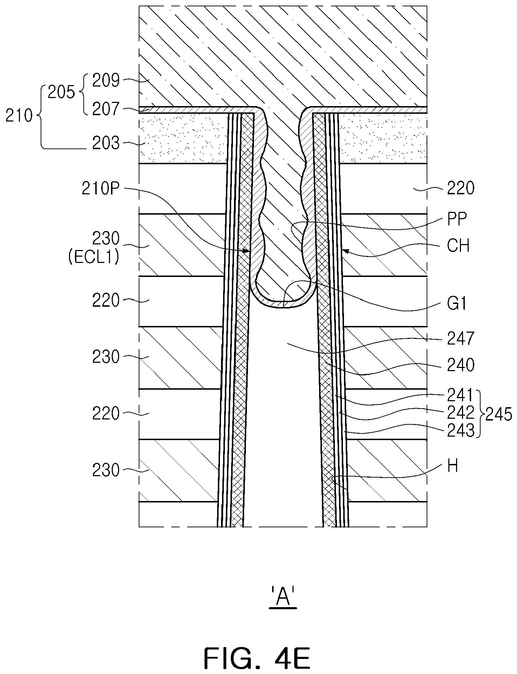

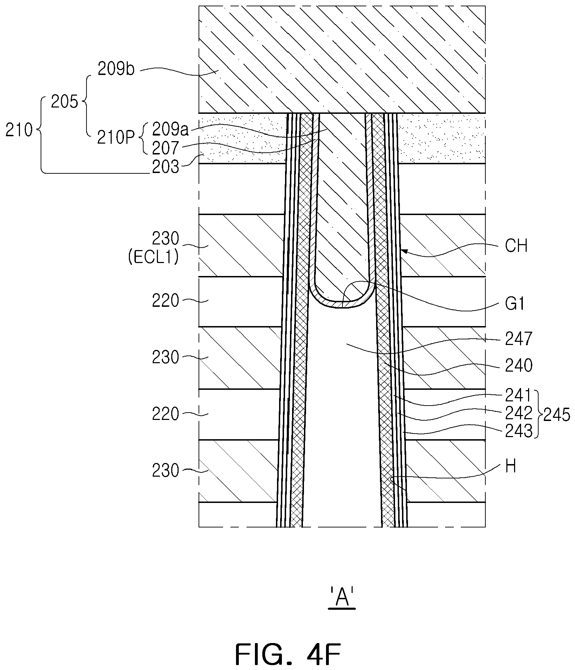

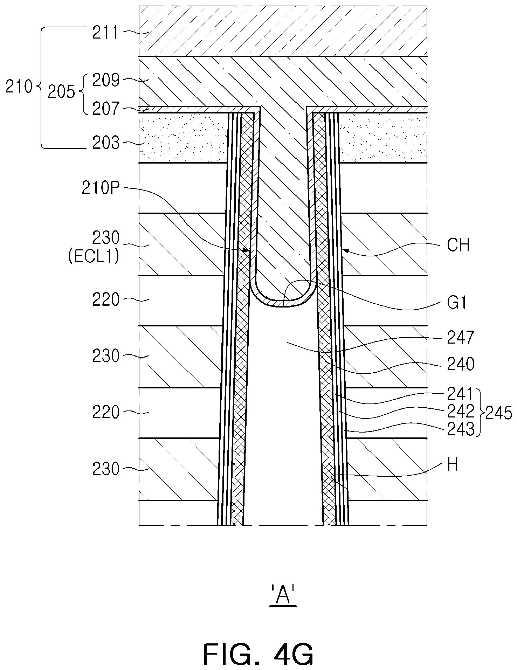

FIGS. 4A, 4B, 4C, 4D, 4E, 4F, and 4G are enlarged cross-sectional diagrams illustrating a portion of an integrated circuit device according to an example embodiment, illustrating a region corresponding to region "A" in FIG. 2. Referring to FIG. 4A, the gate electrodes 230 may include two or more upper erase control gate electrodes ECL1a and ECL1b adjacent to an upper end of the channel structures CH, and a source protrusion pattern 210P may be disposed in the first groove G1' recessed into an upper portion of the core insulating layer 247 to a level lower than a level of the upper surface of the second upper erase control gate electrode ECL1b. The second upper erase control gate electrode ECL1b may be disposed between the first upper erase control gate electrode ECL1a and word lines forming memory cells of the gate electrodes 230. At least a portion of the source protrusion pattern 210P may overlap the first upper erase control gate electrode ECL1a in a horizontal direction and may overlap the second upper erase control gate electrode ECL1b in a horizontal direction. By providing two or more upper erase control gate electrodes ECL1a and ECL1b adjacent to upper ends of the channel structures CH, the efficiency of generating a GIDL current may further improve during an erase operation of the integrated circuit device.

Referring to FIG. 4B, the source protrusion pattern 210P of the second pattern 205 may include N-type impurities and may include polysilicon in which a void (V) is formed. For example, the void V may be formed while the second layer 209 of the second pattern 205 fills the first groove G1. The void V may refer to an empty space surrounded by polysilicon of the second layer 209.

Referring to FIG. 4C, the first layer 207 of the second pattern 205 may have a thickness increasing from a lower portion to an upper portion in the first groove G1. For example, the first layer 207 may include a lower region having a first thickness t1 in the horizontal direction in the first groove G1 and an upper region having a second thickness t2 greater than the first thickness t1 in the horizontal direction in the first groove G1.

Referring to FIG. 4D, the first layer 207 of the second pattern 205 may have a thickness increasing from an upper portion to a lower portion in the first groove G1. For example, the first layer 207 may include a lower region having a first thickness t1a in the horizontal direction in the first groove G1, and an upper region having a second thickness t2a smaller than the first thickness t1a in the horizontal direction in the first groove G1. By increasing the surface area of the first layer 207 overlapping the first erase control gate electrode ECL1 in the horizontal direction, the efficiency of generating GIDL current may further improve during an erase operation of the integrated circuit device.

Referring to FIG. 4E, a semi-spherical grain (HSG) may be formed on the surface of the first layer 207 of the second pattern 205 in the first groove G1. For example, the first layer 207 may have a protrusion portion PP formed on a side surface of the first groove G1 and may have uneven portions. By increasing the surface area of the first layer 207 overlapping the first erase control gate electrode ECL1 in the horizontal direction, the efficiency of generating GIDL current may further improve during an erase operation of the integrated circuit device.

Referring to FIG. 4F, the source protrusion pattern 210P may be disposed in the first groove G1, and the upper surface of the source protrusion pattern 210P may be substantially coplanar with the upper surface of the first pattern 203. The second pattern 205 may include a first pattern portion 209a of the source protruding pattern 210P and a second pattern portion 209b covering the upper surface of the source protruding pattern 210P and the upper surface of the first pattern 203. The second pattern portion 209b may include the same material as a material of the first pattern portion 209a, that is, for example, polysilicon including N-type impurities.

Referring to FIG. 4G, the source structure 210 may further include a third pattern 211 on the second pattern 205. The third pattern 211 may cover the upper surface of the second layer 209 of the second pattern 205 and may extend horizontally. The third pattern 211 may include a material different from a material of the first pattern 203 and a material of the second pattern 205. For example, the third pattern 211 may include a metal material. Since the third pattern 211 includes a metal material having electrical resistance relatively lower than that of a semiconductor material, noise generated by a resistor component of the source structure 210 may be reduced.

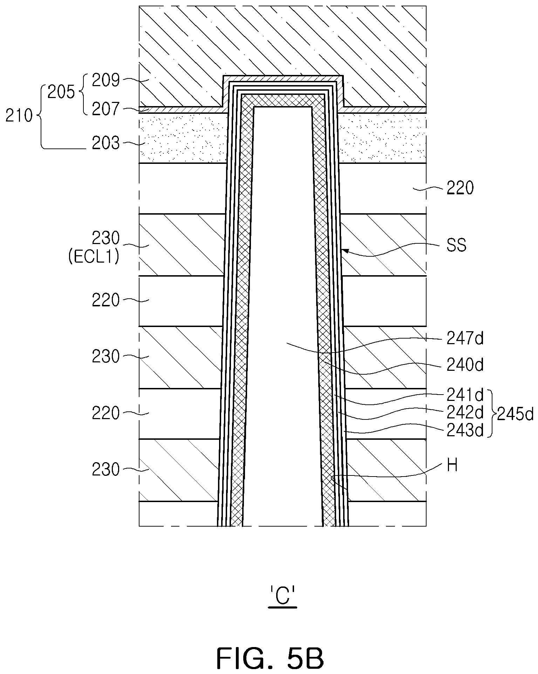

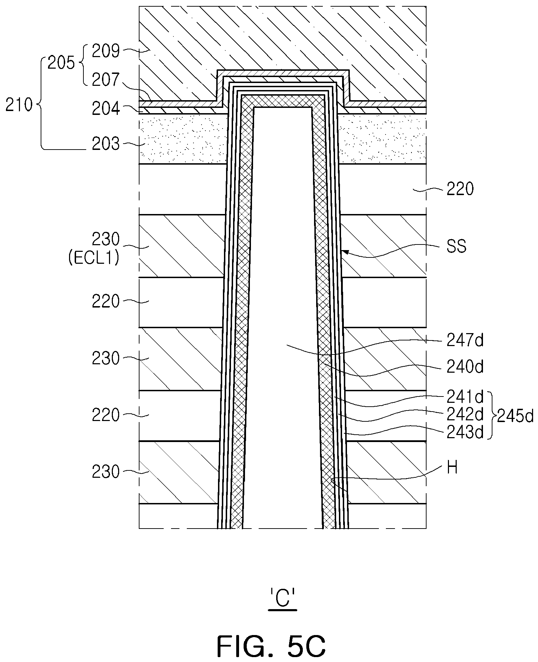

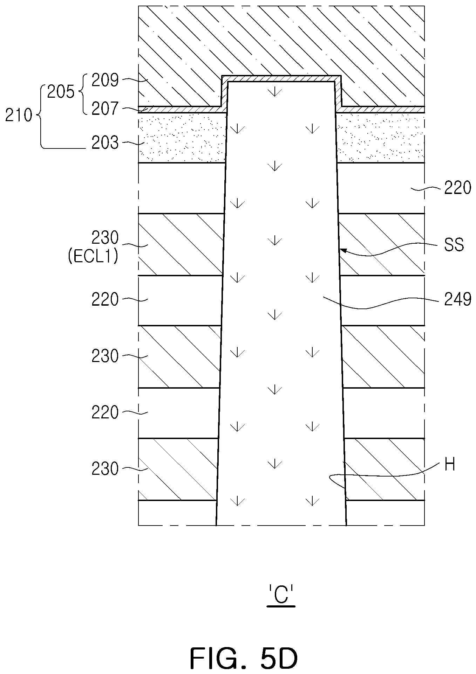

FIGS. 5A, 5B, 5C, and 5D are enlarged cross-sectional diagrams illustrating a portion of an integrated circuit device according to an example embodiment, illustrating a region corresponding to region "C" in FIG. 2. Referring to FIG. 5A, each of the support structures SS may include a dummy core insulating layer 247d, a dummy channel layer 240d surrounding a side surface of the dummy core insulating layer 247d, and a dummy gate dielectric layer 245d disposed between the dummy channel layer 240d and the gate electrodes 230. The dummy gate dielectric layer 245d may include a first dielectric layer 241d, a second dielectric layer 242d, and a third dielectric layer 243d stacked in order from the dummy channel layer 240d. The second pattern 205 may further include a dummy source protrusion pattern 210Pd partially extending into the channel hole H in which the support structures SS are disposed. The dummy source protrusion pattern 210Pd may be disposed in the dummy groove G1d recessed into the upper portion of the dummy core insulating layer 247d to a level lower than a level of the lower surface of the first erase control gate electrode ECL1 in the support structure SS. The dummy source protrusion pattern 210Pd may be in contact with an upper region of an internal side surface of the dummy channel layer 240d and may overlap the first erase control gate electrode ECL1 in a horizontal direction.

Referring to FIG. 5B, the source structure 210 may not include the dummy source protrusion pattern 210Pd, and the dummy channel layer 240d may be spaced apart from the source structure 210 by the dummy gate dielectric layer 245d. The dummy gate dielectric layer 245d may penetrate through the first pattern 203, may extend to a level higher than a level of the upper surface of the first pattern 203, and may cover the upper surface of the dummy channel layer 240d. The first layer 207 of the second pattern 205 may cover an upper region of an external side surface of the dummy gate dielectric layer 245d and an upper surface of the dummy gate dielectric layer 245d.

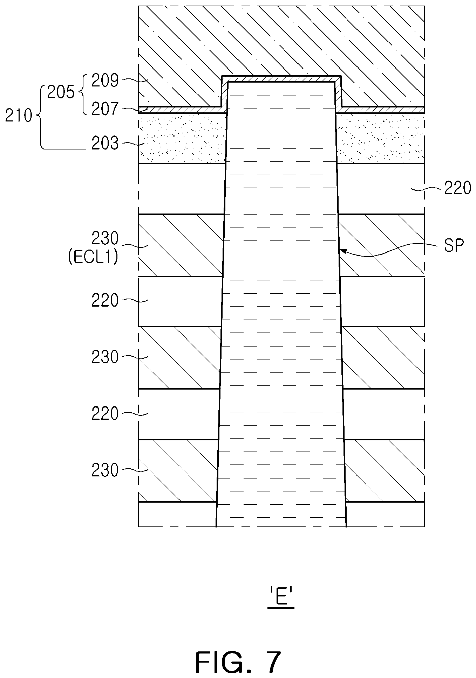

Referring to FIG. 5C, the example of which may be similar to the example in FIG. 5B, but in the example in FIG. 5C, the source structure 210 may further include an insulating layer 204 disposed between the first pattern 203 and the second pattern 205 and between the support structures SS and the second pattern 205. The insulating layer 204 may be locally disposed between the source structure 210 and the support structures SS in the connection region CR of the source structure 210. In another example, the insulating layer 204 may also be disposed between the isolation pattern SP and the second pattern 205 in FIG. 7.

Referring to FIG. 5D, the supporting structure SS may include a support insulating layer 249 filled with silicon oxide therein. The support insulating layer 249 may penetrate through the first pattern 203 and may extend to a level higher than a level of an upper surface of the first pattern 203. The first layer 207 of the second pattern 205 may cover an upper region of an external side surface of the support insulating layer 249 and an upper surface of the support insulating layer 249.

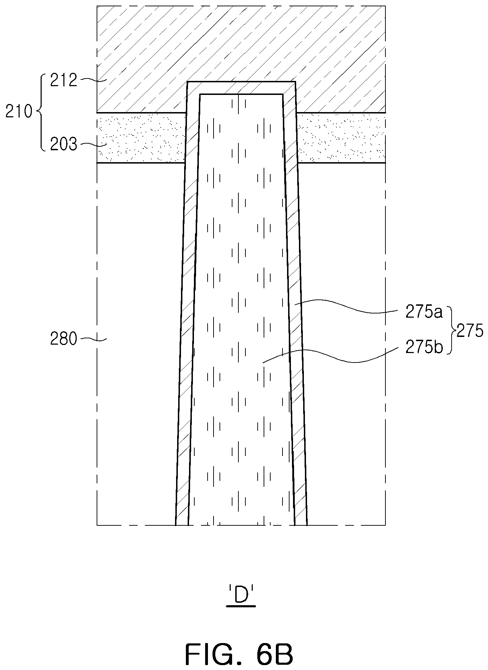

FIGS. 6A and 6B are enlarged cross-sectional diagrams illustrating a portion of an integrated circuit device according to an example embodiment, illustrating a region corresponding to region "D" in FIG. 2. Referring to FIGS. 6A and 6B, the source contact plug 275 may include a barrier layer 275a and a conductive layer 275b. The barrier layer 275a may surround side surfaces and an upper surface of the conductive layer 275b. The conductive layer 275b may include a conductive material, such as, for example, a metal material such as tungsten (W), copper (Cu), or aluminum (Al), and the barrier layer 275a may include, for example, at least one of titanium (Ti), titanium nitride (TiN), tantalum (Ta), tantalum nitride (TaN), tungsten nitride (WN), and tungsten carbon nitride (WCN). The source contact plug 275 may penetrate through the first pattern 203 and may extend to a level higher than a level of an upper surface of the first pattern 203.

In FIG. 6A, the first layer 207 of the second pattern 205 may cover an upper region of a side surface of the source contact plug 275 and an upper surface of the source contact plug 275. In FIG. 6B, the source structure 210 may further include a metal pattern 212. In FIG. 6B, the metal pattern 212 may be in direct contact with the source contact plug 275. The metal pattern 212 may be integrated with the metal pattern 211 in FIG. 4G.

FIG. 7 is an enlarged cross-sectional diagram illustrating a portion of an integrated circuit device according to an example embodiment, illustrating region "E" in FIG. 2. Referring to FIG. 7, the isolation pattern SP may penetrate through the first pattern 203 and may extend to a level higher than a level of the upper surface of the first pattern 203. The second pattern 205 may cover the upper region of the side surface of the isolation pattern SP of the first layer 207 and the upper surface of the isolation pattern SP.

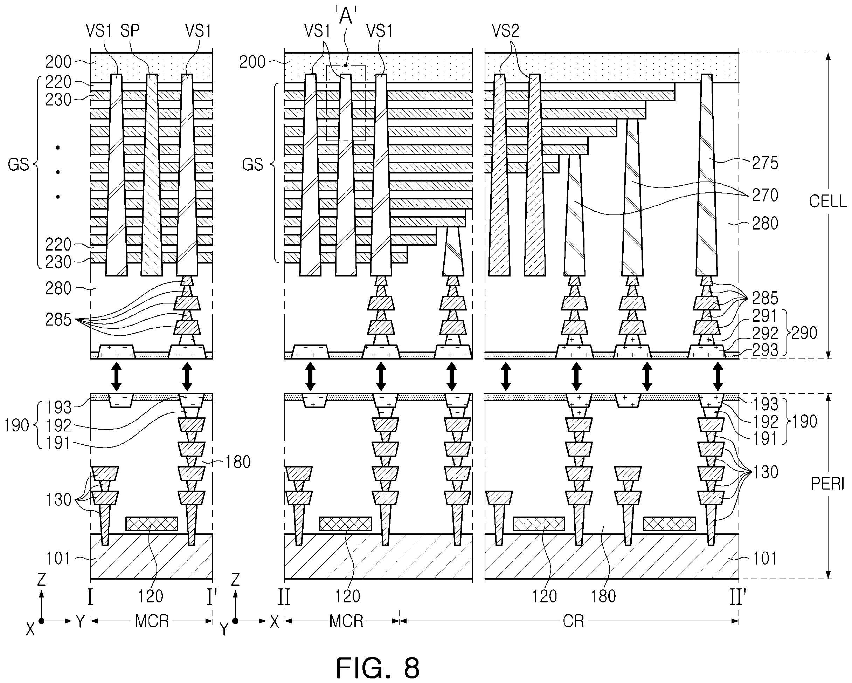

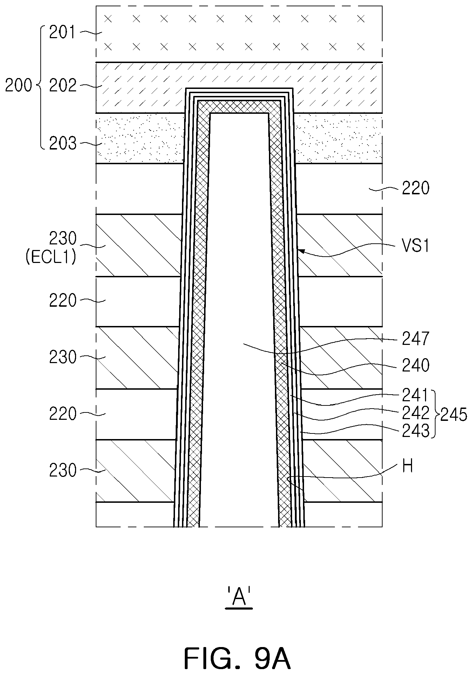

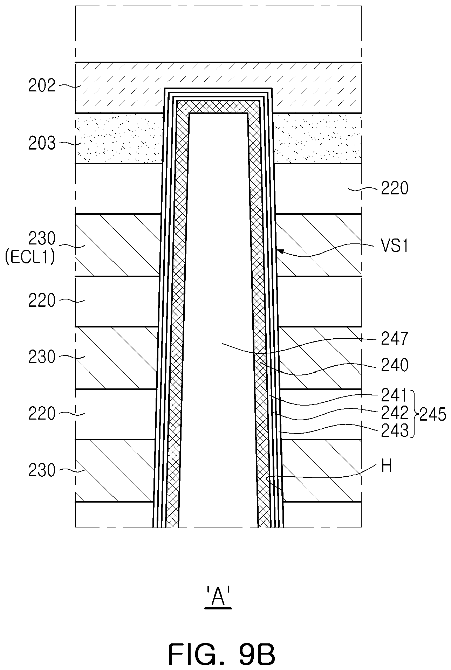

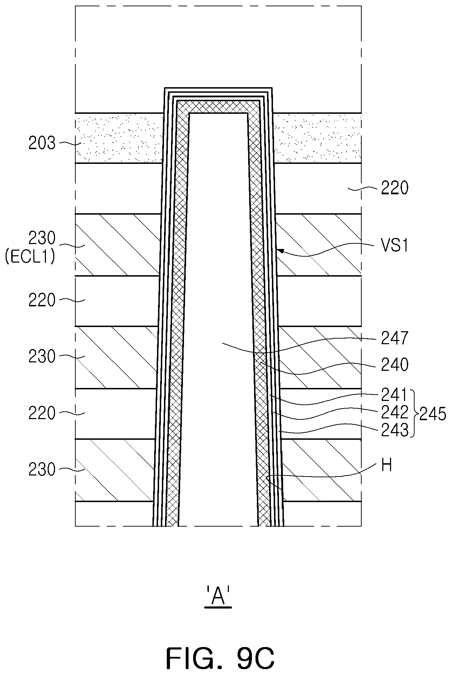

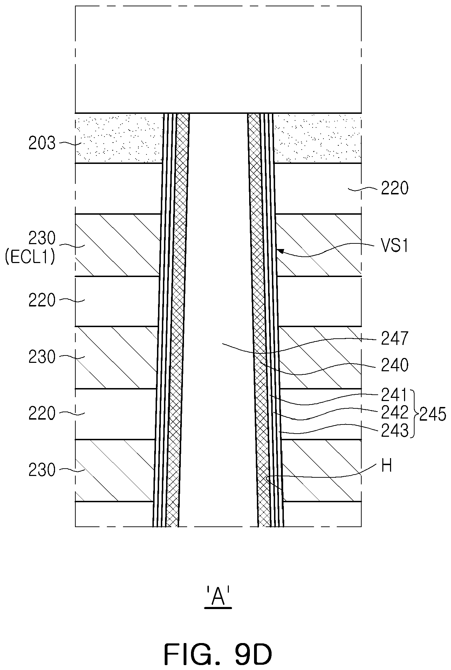

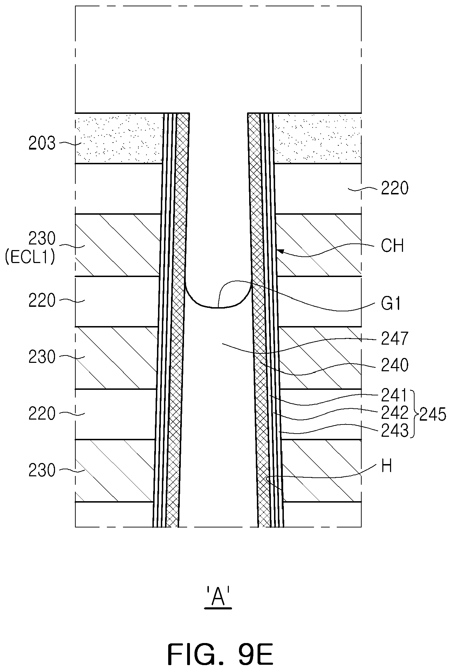

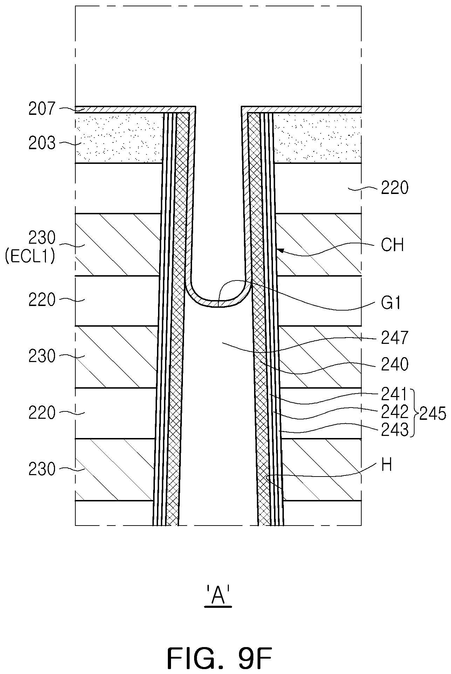

FIGS. 8, 9A, 9B, 9C, 9D, 9E, and 9F are cross-sectional diagrams illustrating a method of manufacturing an integrated circuit device according to an example embodiment. Referring to FIG. 8, the peripheral circuit region PERI may be bonded to the memory cell region CELL. First, device isolation layers may be formed in a substrate 101, and circuit devices 120 may be formed on the substrate 101. By forming the lower wiring structure 130 and the lower bonding structure 190 on the circuit devices 120, the peripheral circuit region PERI may be prepared.

Thereafter, the memory cell region CELL may be prepared by forming interlayer insulating layers 220 and gate electrodes 230 alternately stacked on a rear structure 200, vertical structures VS1 and VS2 penetrating the stack structure GS, an isolation pattern SP, gate contact plugs 270, a source contact plug 275, an upper wiring structure 285, and an upper bonding structure 290. Differently from the example in FIG. 2, the memory cell region CELL in FIG. 8 may include the rear structure 200 instead of the source structure 210 in a position corresponding to the source structure 210. The structure of the rear structure 200 will be described in greater detail with reference to FIG. 9A.

Thereafter, the peripheral circuit region PERI and the memory cell region CELL may be connected to each other by bonding the lower bonding pad 192 to the upper bonding pad 292 by pressing. The lower bonding insulating layer 193 and the upper bonding insulating layer 293 may be connected to each other by bonding by pressing. The memory cell region CELL may be disposed and bonded upside down on the peripheral circuit region PERI such that the upper bonding pad 292 may be oriented downwardly. The peripheral circuit region PERI and the memory cell region CELL may be directly bonded to each other without interposing an adhesive such as an adhesive layer.

Referring to FIG. 9A, the first vertical structure VS1 may be in contact with the rear structure 200, and the rear structure 200 may include a backside substrate 201, an etch-stop layer 202, and a first pattern 203. The first vertical structure VS1 may be formed as a channel structure CH in which the channel layer 240 is electrically connected to the source structure 210 through a subsequent process. The first vertical structure VS1 may penetrate through the first pattern 203 and may be in contact with the etch-stop layer 202. Although not illustrated, in this process, the second vertical structure VS2 and the source contact plug 275 in FIG. 8 may also penetrate through the first pattern 203 and may be in contact with the etch-stop layer 202.

Referring to FIG. 9B, the backside substrate 201 may be removed. The backside substrate 201 may be removed by, for example, a polishing process such as a grinding process or a chemical mechanical polishing process.

Referring to FIG. 9C, the etch-stop layer 202 may be removed. The etch-stop layer 202 may be formed of, for example, silicon nitride, and may be selectively removed with respect to the first pattern 203 including polysilicon. An upper portion of the first vertical structure VS1 may be exposed.

Referring to FIG. 9D, the channel layer 240 and the core insulating layer 247 may be exposed by etching an upper portion of the first vertical structure VS1.

Referring to FIG. 9E, a first groove G1 may be formed by recessing an upper portion of the core insulating layer 247. A lower end of the first groove G1 may be disposed on a level lower than a level of a lower surface of the first erase control gate electrode ECL1. Recessing the upper portion of the core insulating layer 247 may include selectively etching the core insulating layer 247 with respect to the channel layer 240, the gate dielectric layer 245, and the first pattern 203. However, during the etching process, an upper portion of the data storage layer 242 included in the gate dielectric layer 245 may also be partially recessed. A depth of the lower end of the first groove G1 may be varied in example embodiments.

Referring to FIG. 9F, the first layer 207 extending horizontally on the first pattern 203 and conformally extending into the first groove G1 may be formed. The first layer 207 may be formed of undoped polysilicon. The first layer 207 may be formed to have a thickness in a range of about 10 nm to about 150 nm. Thereafter, the second pattern 205 may be formed by forming the second layer 209 formed of polysilicon including N-type impurities. The first pattern 203 may be formed to have a greater thickness in a region around the narrow entrance of the first groove G1, and the second pattern 205 may have a void formed therein.

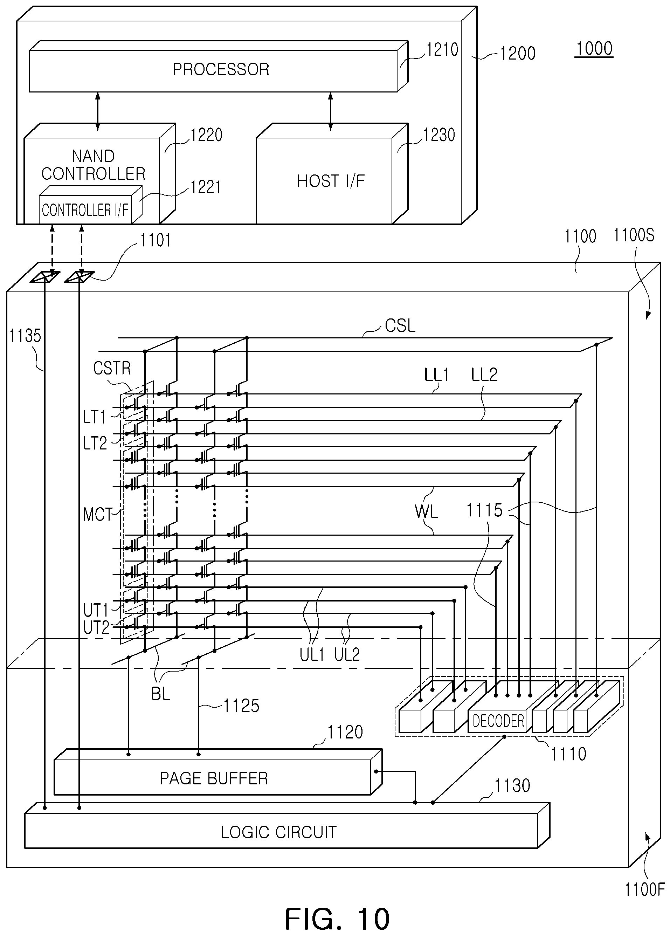

FIG. 10 is a diagram illustrating a data storage system including an integrated circuit device according to an example embodiment. Referring to FIG. 10, the data storage system 1000 may include an integrated circuit device 1100 and a controller 1200 electrically connected to the integrated circuit device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The integrated circuit device 1100 may be implemented as a non-volatile memory device, such as, for example, the NAND flash memory device described in the aforementioned example embodiment with reference to FIGS. 1 to 7. The integrated circuit device 1100 may include a first semiconductor structure 1100F and a second semiconductor structure 1100S on the first semiconductor structure 1100F. In example embodiments, the first semiconductor structure 1100F may be disposed on the side of the second semiconductor structure 1100S. The first semiconductor structure 1100F may be implemented as a peripheral circuit structure including a decoder circuit 1110, a page buffer 1120, and a logic circuit 1130. The second semiconductor structure 1100S may be implemented as a memory cell structure including a bit line BL, a common source line CSL, word lines WL, first and second gate upper lines UL1 and UL2, first and second gate lower lines LL1 and LL2 and memory cell strings CSTR disposed between the bit line BL and the common source line CSL.

In the second semiconductor structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in example embodiments.

In example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection wirings 1115 extending from the first semiconductor structure 1100F to the second semiconductor structure 1100S. The bit lines BL may be electrically connected to the page buffer 1120 through second connection wirings 1125 extending from the first semiconductor structure 1100F to the second semiconductor structure 1100S.

In the first semiconductor structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The integrated circuit device 1100 may communicate with the controller 1200 through the input/output pad 1101 electrically connected to the logic circuit 1130. The input/output pad 1101 may be electrically connected to the logic circuit 1130 through an input/output connection wiring 1135 extending from the first semiconductor structure 1100F to the second semiconductor structure 1100S.

The controller 1200 may include a processor 1210, a NAND controller 1220, and a host interface 1230. In example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the integrated circuit device 1100 by controlling the NAND controller 1220. The NAND controller 1220 may include a controller interface 1221 processing communication with the integrated circuit device 1100. Through the controller interface 1221, a control command for controlling the integrated circuit device 1100, data to be written to the memory cell transistors MCT of the integrated circuit device 1100, and data to be read from the memory cell transistors MCT of the integrated circuit device 1100 may be transmitted. The host interface 1230 may provide a communication function between the data storage system 1000 and an external host. When a control command from an external host is received through the host interface 1230, the processor 1210 may control the integrated circuit device 1100 in response to the control command.

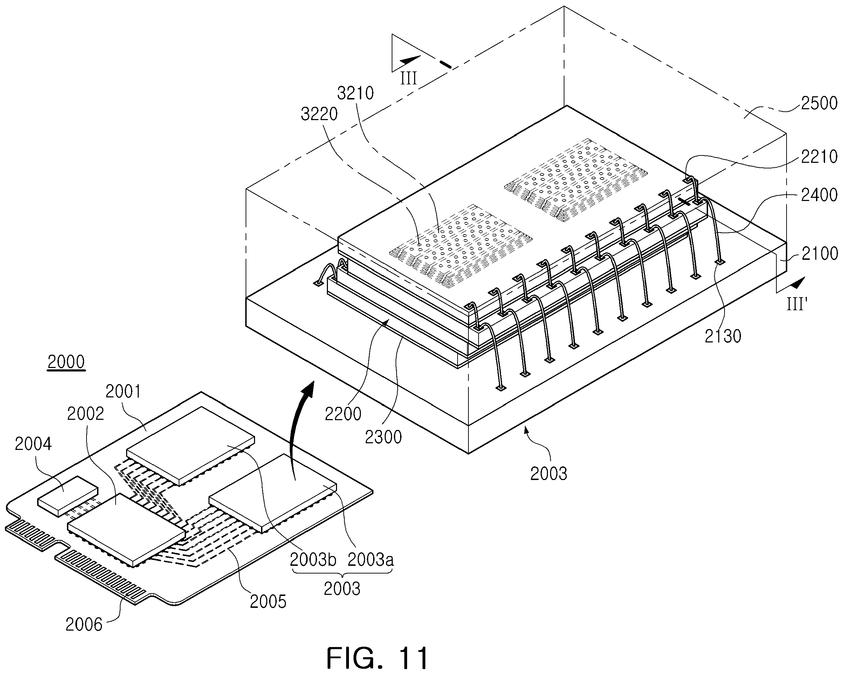

FIG. 11 is a perspective diagram illustrating a data storage system including an integrated circuit device according to an example embodiment. Referring to FIG. 11, a data storage system 2000 in an example embodiment may include a main substrate 2001, a controller 2002 mounted on the main substrate 2001, one or more semiconductor packages 2003, and a DRAM 2004. The semiconductor package 2003 and the DRAM 2004 may be connected to the controller 2002 by wiring patterns 2005 formed on the main substrate 2001.

The main substrate 2001 may include a connector 2006 including a plurality of pins coupled to an external host. The number and arrangement of the plurality of pins in the connector 2006 may vary depending on a communication interface between the data storage system 2000 and the external host. In example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000. The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 18. Each of the semiconductor chips 2200 may include gate stack structures 3210 and channel structures 3220. Each of the semiconductor chips 2200 may include the integrated circuit device described in the aforementioned example embodiment with reference to FIGS. 1 to 7.

In example embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In example embodiments, the controller 2002 and the semiconductor chips 2200 may be included in a single package. In an example embodiment, the controller 2002 and the semiconductor chips 2200 may be mounted on a separate interposer substrate different from the main board 2001, and the controller 2002 and the semiconductor chips 2200 may be connected to each other through wiring formed on the interposer substrate.

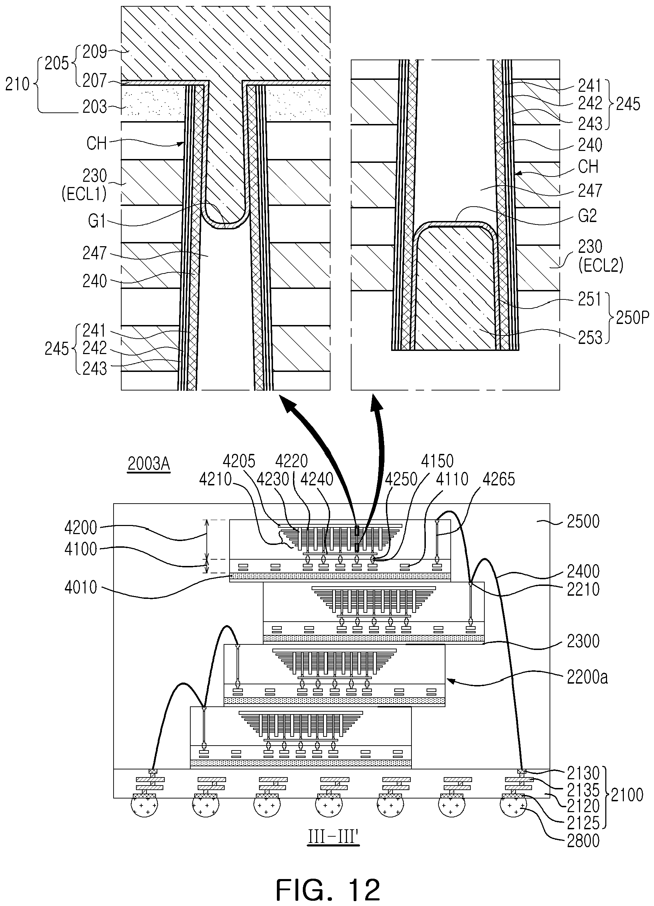

FIG. 12 is a cross-sectional diagram illustrating a semiconductor package according to an example embodiment, illustrating a semiconductor package in FIG. 11 taken along line III-III' in FIG. 11. Referring to FIG. 12, in the semiconductor package 2003, the package substrate 2100 may be implemented as a printed circuit board. The package substrate 2100 may include a package substrate body 2120, package upper pads 2130 (see FIG. 11) disposed on the upper surface of the package substrate body 2120, lower pads 2125 disposed on the lower surface of the package substrate body 2120 or exposed through the lower surface, and internal wirings 2135 electrically connecting the upper pads 2130 to the lower pads 2125 in the package substrate body 2120. The lower pads 2125 may be connected to the wiring patterns 2005 of the main substrate 2001 of the data storage system 2000 as illustrated in FIG. 11 through conductive connection portions 2800.

In the semiconductor package 2003a, each of the semiconductor chips 2200a may include a semiconductor substrate 4010, a first structure 4100 disposed on the semiconductor substrate 4010, and a second structure 4200 bonded to the first structure 4100 on the first structure 4100 by a wafer bonding method.

The first structure 4100 may include a peripheral circuit region including the peripheral wiring 4110 and the first bonding structures 4150. The second structure 4200 may include a common source line 4205, a gate stack structure 4210 disposed between the common source line 4205 and the first structure 4100, memory channel structures 4220 and isolation patterns 4230 penetrating through the gate stack structure 4210, and a second bonding structures 4250 electrically connected to the memory channel structures 4220 and the word lines (WL in FIG. 10) of the gate stack structure 4210, respectively. For example, the second bonding structures 4250 may be electrically connected to the memory channel structures 4220 and the word lines (WL in FIG. 10) through the bit lines 4240 electrically connected to the memory channel structures 4220 and gate connection wirings 275 (in FIG. 2) electrically connected to the word lines (WL in FIG. 10). The first bonding structures 4150 of the first structure 4100 and the second bonding structures 4250 of the second structure 4200 may be in contact with and bonded to each other. Bonded portions of the first bonding structures 4150 and the second bonding structures 4250 may be formed of, for example, copper (Cu).

As illustrated in the enlarged diagram, each of the first structure 4100 and the second structure 4200 may include a peripheral circuit area PERI and a memory cell array area CELL. Each of the semiconductor chips 2200a may include a source structure 210, gate electrodes 230, and channel structures CH as illustrated in the enlarged diagram. Each of the semiconductor chips 2200a may further include an input/output pad 2210 and an input/output connection wiring 4265 disposed below the input/output pad 2210. The input/output connection wiring 4265 may be electrically connected to a portion of the second bonding structures 4210.

The semiconductor chips 2200a in FIG. 12 may be electrically connected to each other by connection structures 2400 having a form of bonding wires. However, in example embodiments, semiconductor chips in a semiconductor package, such as the semiconductor chips 2200a in FIG. 12, may be electrically connected to each other by a connection structure including a through electrode TSV.

According to the aforementioned example embodiments, by disposing patterns for improving the efficiency of generating GIDL current during an erase operation in channel structures, an integrated circuit device having improved electrical properties and a data storage system including the same may be provided.

While the example embodiments have been illustrated and described above, it will be configured as apparent to those skilled in the art that modifications, variations, and combinations of example embodiments could be made without departing from the scope of the present disclosure as defined by the appended claims.

Further Embodiments are set out in the following Numbered Paragraphs (NPs):
NP1. An integrated circuit device, comprising:
   a first structure including a substrate, circuit devices on the substrate, a lower wiring structure electrically connected to the circuit devices, and a lower bonding structure on the lower wiring structure; and
   a second structure on the first structure, said second structure including a source structure, gate electrodes between the first structure and the source structure, channel structures penetrating through the gate electrodes, an upper wiring structure extending below the gate electrodes and the channel structures, and an upper bonding structure that extends below the upper wiring structure and is bonded to the lower bonding structure within the first structure;
   wherein the gate electrodes include a first erase control gate electrode, a second erase control gate electrode extending between the first erase control gate electrode and the upper wiring structure, and a plurality of word lines extending between the first erase control gate electrode and the second erase control gate electrode;
   wherein each of the channel structures includes a core insulating layer, a channel layer surrounding a side surface of the core insulating layer, a gate dielectric layer between the channel layer and the gate electrodes, and a pad pattern in contact with a lower region of an internal side surface of the channel layer;
   wherein the source structure includes a first pattern in contact with an upper region of a side surface of the gate dielectric layer, and a second pattern extending on the first pattern;
   wherein a first groove, which is recessed into an upper portion of the core insulating layer to a level lower than a level of a lower surface of the first erase control gate electrode, extends in the channel structures; and
   wherein the second pattern includes a source protrusion pattern that extends into the first groove, is in contact with an upper region of an internal side surface of the channel layer, and overlaps the first erase control gate electrode in a horizontal direction.
NP2. The device of NP1, wherein the second pattern includes a first portion in contact with the upper region of the internal side surface of the channel layer in the first groove and a second portion on the first portion; wherein the first portion includes polysilicon; and wherein the second portion includes polysilicon having N-type impurities therein.
NP3. The device of NP2, wherein the first portion includes N-type impurities at a first concentration; and wherein the second portion includes N-type impurities at a second concentration greater than the first concentration.
NP4.The device of NP2, wherein the first portion extends horizontally to the gate dielectric layer and an upper surface of the first pattern.
NP5. The device of NP3, wherein the second portion fills at least a portion of an internal space of the first portion in the first groove.
NP6. The device of NP1, wherein the pad pattern overlaps the second erase control gate electrode in a horizontal direction; wherein the pad pattern includes a third portion in contact with a lower region of the internal side surface of the channel layer and a fourth portion on the third portion; wherein the third portion includes polysilicon; and wherein the fourth portion includes polysilicon having N-type impurities therein.
NP7. The device of NP6, wherein the third portion includes N-type impurities at a third concentration; wherein the fourth portion includes N-type impurities at a fourth concentration greater than the third concentration.
NP8. The device of NP1, wherein the gate electrodes further include a third erase control gate electrode extending between the first erase control gate electrode and the word lines; and wherein at least a portion of the source protrusion pattern overlaps the third erase control gate electrode in the horizontal direction.
NP9. The device of NP1, wherein the second pattern includes N-type impurities and polysilicon having a void formed therein.
NP10. The device of NP1,
   wherein the source structure includes a first region and a second region;
   wherein the channel structures are in contact with the first region of the source structure;
   wherein the gate electrodes form a step structure below the second region of the source structure; and
   wherein the semiconductor structure further includes support structures penetrating through the gate electrodes below the second region of the source structure.
NP11. The device of NP10, wherein each of the support structures includes a dummy core insulating layer, a dummy channel layer surrounding a side surface of the dummy core insulating layer, and a dummy gate dielectric layer between the dummy channel layer and the gate electrodes.
NP12. The device of NP1, wherein the source protrusion pattern comprises a doped polysilicon layer, and an undoped polysilicon layer extending between the doped polysilicon layer and a channel structure.
NP13. The device of NP12, wherein the channel structure comprises a channel layer, which electrically contacts a portion of the undoped polysilicon layer extending opposite the sidewall of the first erase control gate electrode.
NP14. A data storage system, comprising:
   a semiconductor storage device including a first structure including a substrate, circuit devices on the substrate, and a lower bonding structure on the circuit devices, a second structure including a source structure, gate electrodes below the source structure, channel structures disposed in channel holes and penetrating through the gate electrodes, and an upper bonding structure below the gate electrodes and the channel structures and bonded to the lower bonding structure, and an input/output pad electrically connected to the circuit devices; and
   a controller electrically connected to the semiconductor storage device through the input/output pad and configured to control the semiconductor storage device;
   wherein the gate electrodes include a first erase control gate electrode, a second erase control gate electrode below the first erase control gate electrode, and word lines between the first erase control gate electrode and the second erase control gate electrode;
   wherein each of the channel structures includes a core insulating layer, a channel layer surrounding a side surface of the core insulating layer, a gate dielectric layer between the channel layer and the gate electrodes, and a pad pattern below the core insulating layer;
   wherein a first groove recessed into an upper portion of the core insulating layer to a level lower than a level of a lower surface of the first erase control gate electrode and a second groove recessed into a lower portion of the core insulating layer to a level higher than a level of an upper surface of the second erase control gate electrode in each of the channel structures;
   wherein the source structure includes a source protrusion pattern extending into the first groove; and
   wherein the pad pattern is disposed in the second groove.
NP15. The data storage system of NP14,
   wherein the source protrusion pattern includes a first portion in contact with an upper region of an internal side surface of the channel layer and a second portion disposed on the first portion in the first groove;
   wherein the first portion includes polysilicon including impurities of a first concentration;
   wherein the second portion includes polysilicon including impurities of a second concentration; and
   wherein the first concentration is less than the second concentration.

## Claims

1. An integrated circuit device, comprising:
a first structure including a substrate, circuit devices on the substrate, a lower wiring structure electrically connected to the circuit devices, and a lower bonding structure on the lower wiring structure; and
a second structure on the first structure, said second structure including a source structure, gate electrodes between the first structure and the source structure, channel structures penetrating through the gate electrodes, an upper wiring structure below the gate electrodes and the channel structures, and an upper bonding structure below the upper wiring structure and is bonded to the lower bonding structure within the first structure;
wherein the gate electrodes include a first erase control gate electrode, a second erase control gate electrode between the first erase control gate electrode and the upper wiring structure, and a plurality of word lines between the first erase control gate electrode and the second erase control gate electrode;
wherein each of the channel structures includes a core insulating layer, a channel layer surrounding a side surface of the core insulating layer, a gate dielectric layer between the channel layer and the gate electrodes, and a pad pattern in contact with a lower region of an internal side surface of the channel layer;
wherein the source structure includes a first pattern in contact with an upper region of a side surface of the gate dielectric layer, and a second pattern on the first pattern;
wherein a first groove, which is recessed into an upper portion of the core insulating layer to a level lower than a level of a lower surface of the first erase control gate electrode, extends in the channel structures; and
wherein the second pattern includes a source protrusion pattern that extends into the first groove, is in contact with an upper region of an internal side surface of the channel layer, and overlaps the first erase control gate electrode in a horizontal direction.

2. The device of Claim 1, wherein the second pattern includes a first portion in contact with the upper region of the internal side surface of the channel layer in the first groove and a second portion on the first portion; wherein the first portion includes polysilicon; and wherein the second portion includes polysilicon having N-type impurities therein.

3. The device of Claim 2, wherein the first portion includes N-type impurities at a first concentration; and wherein the second portion includes N-type impurities at a second concentration greater than the first concentration.

4. The device of claim 2 or claim 3, wherein the first portion extends horizontally to the gate dielectric layer and an upper surface of the first pattern.

5. The device of any one of claims 2-4, wherein the second portion fills at least a portion of an internal space of the first portion in the first groove.

6. The device of any preceding claim, wherein the pad pattern overlaps the second erase control gate electrode in a horizontal direction; wherein the pad pattern includes a third portion in contact with a lower region of the internal side surface of the channel layer and a fourth portion on the third portion; wherein the third portion includes polysilicon; and wherein the fourth portion includes polysilicon having N-type impurities therein.

7. The device of Claim 6, wherein the third portion includes N-type impurities at a third concentration; wherein the fourth portion includes N-type impurities at a fourth concentration greater than the third concentration.

8. The device of any preceding claim, wherein the gate electrodes further include a third erase control gate electrode between the first erase control gate electrode and the word lines; and wherein at least a portion of the source protrusion pattern overlaps the third erase control gate electrode in the horizontal direction.

9. The device of any preceding claim, wherein the second pattern includes N-type impurities and polysilicon having a void formed therein.

10. The device of any preceding claim,
wherein the source structure includes a first region and a second region;
wherein the channel structures are in contact with the first region of the source structure;
wherein the gate electrodes form a step structure below the second region of the source structure; and
wherein the semiconductor structure further includes support structures penetrating through the gate electrodes below the second region of the source structure.

11. The device of Claim 10, wherein each of the support structures includes a dummy core insulating layer, a dummy channel layer surrounding a side surface of the dummy core insulating layer, and a dummy gate dielectric layer between the dummy channel layer and the gate electrodes.

12. The device of any preceding claim, wherein the source protrusion pattern comprises a doped polysilicon layer, and an undoped polysilicon layer extending between the doped polysilicon layer and a channel structure.

13. The device of Claim 12, wherein the channel structure comprises a channel layer, which electrically contacts a portion of the undoped polysilicon layer extending opposite the sidewall of the first erase control gate electrode.

14. The device of any preceding claim, further comprising a second groove recessed into a lower portion of the core insulating layer to a level higher than a level of an upper surface of the second erase control gate electrode in each of the channel structures, wherein the pad pattern is disposed in the second groove.

15. A data storage system, comprising:
an integrated circuit device according to any preceding claim;
an input/output pad electrically connected to the circuit devices; and
a controller electrically connected to the integrated circuit device through the input/output pad and configured to control the integrated circuit device.
